# EUROPEAN PATENT SPECIFICATION

(11) **EP 0 443 368 B1**
(45) Date of publication and mention of the grant of the patent: **19.06.1996**
(21) Application number: 91101602.0
(22) Date of filing: 06.02.1991
(51) Int. Cl.: H03F 3/60, H03F 1/34

(54) **Constant-amplitude wave combination type amplifier**
Verstärker für kombinierte Wellen mit konstanter Amplitude
Amplificateur pour ondes d'amplitude constante combinées

(30) Priority: 07.02.1990 JP 27698/90; 07.02.1990 JP 27699/90; 07.02.1990 JP 27700/90
(43) Date of publication of application: 28.08.1991
(60) Divisional application: 94117668.7
(73) Proprietor: FUJITSU LIMITED, Kawasaki-shi, Kanagawa 211 (JP)
(72) Inventor: Okubo, Naofumi, Kawasaki-shi, Kanagawa, 212 (JP); Asano, Yoshihiko, Tokyo, 146 (JP); Kurihara, Hiroshi, Tokyo, 166 (JP); Daido, Yoshimasa, Yokohama-shi, Kanagawa, 241 (JP); Kobayashi, Kazuhiko, Kawasaki-shi, Kanagawa, 214 (JP); Kobayakawa, Shuji, Yokohama-shi, Kanagawa, 240 (JP); Maniwa, Toru, Kawasaki-shi, Kanagawa, 211 (JP)
(74) Representative: Lehn, Werner, Dipl.-Ing.

(56) References cited:
- GB-A- 2 010 039
- US-A- 3 909 742
- US-A- 4 490 684
- US-A- 4 656 434

## Description

### BACKGROUND OF THE INVENTION

The present invention relates to a constant-amplitude wave combination type amplifier comprising a first amplifier outputting a first amplified output, a second amplifier outputting a second amplified output, first wave combining means, coupled to said first and second amplifiers, for combining said first and second constant-amplitude waves and for generating an output wave. An amplifier of this kind is known from US-A-39 09 742.

Recently, constant-amplitude wave combination type amplifiers have been widely used in various communication devices, such as radio devices for use in mobile communications, multiple radio devices, satellite communication radio devices, and broadcasting devices. There is a need to realize such constant-amplitude wave combination amplifiers which consume a small amount of power and which are configured of a small number of structural elements.

Constant-amplitude wave combination type amplifiers based on the LINC process (linear amplification with non-linear components) are known as amplifiers which meet the above-mentioned need, and are disclosed in, for example D.C. Cox, "Linear Amplification with Non-linear Components", IEEE Transactions on Communications, December 1974, pp. 1942-1945. An application of constant-amplitude wave combination type amplifiers based on the LINC process is proposed in Japanese Laid-Open Patent Application No. 1-284106.

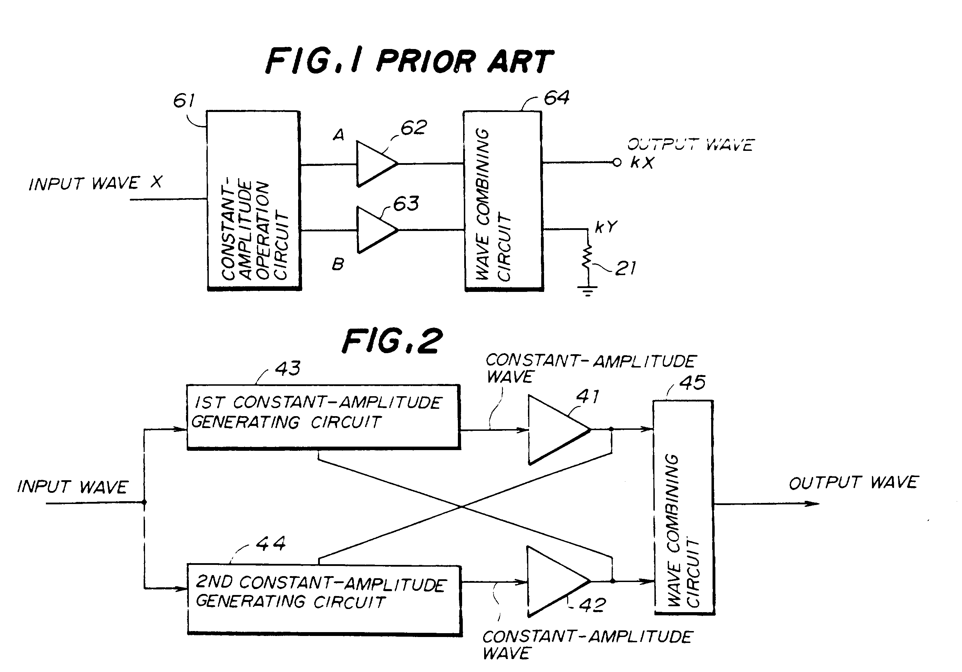

Fig. 1 shows a conventional constant-amplitude wave combination type amplifier. As shown, the amplifer has a constant-amplitude wave operation circuit 61, two amplifiers 62 and 63, and a wave combination circuit 64. The constant-amplitude wave operation circuit 61 is formed of a digital signal processing cicuit, and calculates an orthognal wave Y orthogonal to an input wave X so that each combined wave obtained by combining the waves X and Y with each other has a constant amplitude. Then, the constant-amplitude wave operation circuit 61 outputs constant-amplitude waves A and B which have constant envelopes having equal amplitudes by the above-mentioned combination of the waves X and Y. Capital letters X, Y, A and B are vector amounts which include phases.

The amplifiers 62 and 63, which are formed of non-linear amplifiers such as C-class amplifiers, amplify the constant-amplitude waves A and B, respectively. The wave combining circuit 64 combines constant amplitude waves kA and kB respectively output by the amplifiers 62 and 63, and generates an output wave kX which is an amplified version of the input wave X.

The conventional configuration shown in FIG.1 has an advantage in that the amplifiers 62 and 63 are not required to be formed of linear amplifiers, since it is sufficient to amplify the constant-amplitude waves A and B of the constant envelopes. In addition, since the original signal can be reproduced by the wave combining circuit 64, it is possible to linearly amplify the input wave X having little distortion irrespective of the use of the non-linear amplifiers.

As has been described previously, the constant-amplitude wave operation circuit 61 is formed of a digital signal processing circuit. However, the digital signal processing circuit consumes a large amount of power and is not suitable for high-speed signal processing. Further, the use of the digital signal processing circuit causes an increase in the size of the amplifier. For the above reasons, the use of conventional constant-amplitude wave combination type amplifiers is limited to special applications in which the amount of power consumed in the digital signal processing circuit or the size of the amplifier are negligible, or applications in which data is transferred at a low speed.

### SUMMARY OF THE INVENTION

It is the object of the present invention to provide a constant-amplitude wave combination amplifier which consumes a small amount of power, is formed of a small number of structural elements and operates at a high speed.

The above-mentioned object of the present invention is achieved by first constant-amplitude wave generating means, coupled to said first and second amplifiers, for combining an input wave and said second amplified output from said second amplifier and for generating a first constant-amplitude wave which is input to said first amplifier, second constant-amplitude wave generating means, coupled to said first and second amplifiers, for combining said input wave and said first amplified output from said first amplifier and for generating a second constant-amplitude wave.

### BRIEF DESCRIPTION OF THE DRAWINGS

Other objects, features and advantages of the present invention will become more apparent from the following detailed description when read in conjunction with the accompanying drawings, in which:
FIG.1 is a block diagram of a conventional constant-amplitude wave combination type amplifier;
FIG.2 is a block diagram illustrating an outline of a constant-amplitude wave combination type amplifier according to a first preferred embodiment of the present invention;
FIG.3 is a block diagram illustrating the configuration shown in FIG.2 in more detail;
FIG.4 is a graph illustrating the principle of the operation of the configuration shown in FIG.3;
FIG.5 is a block diagram illustrating the operation of the configuration shown in FIG.3;
FIG.6 is a block diagram illustrating a variation of the configuration shown in FIG.3;
FIG.7 is a block diagram illustrating an outline of a constant-amplitude wave combination type amplifier according to a second preferred embodiment of the present invention;
FIG.8 is a block diagram illustrating the configuration shown in FIG.7 in more detail;

### DESCRIPTION OF THE PREFERRED EMBODIMENTS

FIG.2 shows an outline of a constant-amplitude wave combination type amplifier according to a first preferred embodiment of the present invention. The amplifier shown in FIG.2 has a first constant-amplitude wave generating circuit 43, a second constant-amplitude wave generating circuit 44, first and second amplifiers 41 and 42, and a wave combining circuit 45. The first constant-amplitude wave generating circuit 43 combines an amplified output from the second amplifier 42 and an input wave, and generates a first constant-amplitude wave. The second constant-amplitude wave generating circuit 44 combines an amplified output from the first amplifier 41 and the input wave, and generates a second constant-amplitude wave. The first and second amplifiers 41 and 42 amplify the first and second constant-amplitude waves output by the first and second constant-amplitude wave generating circuits 43 and 44, respectively. The wave combining circuit 45 combines the amplified outputs from the first and second amplifiers 41 and 42, and generates an output wave.

The amplified output from the first amplifier 41 is fed back to the input of the second amplifier 42 via the second constant-amplitude wave generating circuit 44. Similarly, the amplified output from the second amplifier 42 is fed back to the input of the first amplifier 41 via the first constant-amplitude wave generating circuit 43. Thus, the circuit shown in FIG.2 is stable in an oscillation state. In the stable oscillation state, the first and second constant-amplitude waves respectively generated by the first and second constant-amplitude wave generating circuits 43 and 44 have envelopes having constant amplitudes. As a result, it becomes possible to form the first and second amplifiers 41 and 42 of high-efficient non-linear amplifiers. It is also possible to form the first and second constant-amplitude wave generating circuits 43 and 44 of analog circuits. As a result, the configuration shown in FIG.2 consumes a small amount of power, operates at a high speed and can be formed of a small number of structural elements.

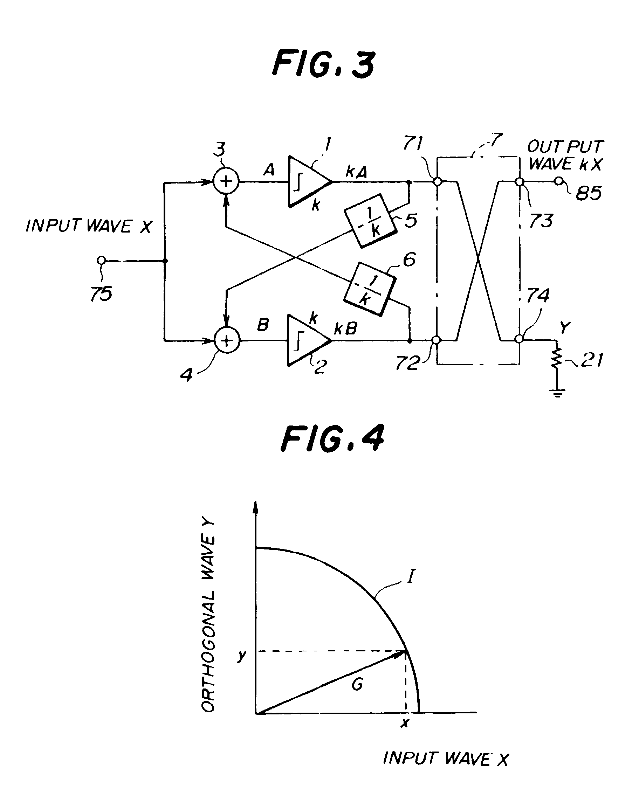

FIG.3 shows the configuration of the amplifier shown in FIG.2 in more detail. The configuration shown in FIG.3 has amplifiers 1 and 2, which correspond to the first and second amplifiers 41 and 42 shown in FIG.3, respectively. The amplifiers 1 and 2 are formed of amplifiers, each having an amplification gain 'k', and receive constant-amplitude waves A and B, respectively. The amplifiers 1 and 2 can be formed of high-efficient non-linear amplifiers, such as C-class amplifiers. An amplified output kA from the amplifier 1 is input to an attenuator 5 and an input terminal 71 of an in-phase hybrid circuit 7 corresponding to the wave combining circuit 45 shown in FIG.2. An amplified output kB from the amplifier 2 is input to an attenuator 6 and an input terminal 72 of the in-phase hybrid circuit 7.

The attenuator 5 attenuates the amplified signal kA by -1/k. Similarly, the attenuator 6 attenuates the amplified signal kB by -1/k. An output signal of the attenuator 5 is input to an adder 4 corresponding to the first constant-amplitude wave generating circuit 43 shown in FIG.2, and an output signal of the attenuator 6 is input to an adder 3 corresponding to the second constant-amplitude wave generating circuit 44 shown in FIG.2. An input wave X is applied to the adders 3 and 4 via an input terminal 75. The adder 3 adds the input wave X and the amplified signal kB passing through the attenuator 6, and generates the constant-amplitude wave A, which is input to the amplifier 1. Similarly, the adder 4 adds the input wave X and the amplified signal kA passing through the attenuator 5, and generates the constant-amplitude wave B, which is input to the amplifier 2. It will be noted that the adders 3 and 4 and the hybrid circuit 4 can be formed of analog circuits.

The in-phase hybrid circuit 7 receives the amplified signals kA and kB via the input terminals 71 and 72, respectively, and branches each of the amplified signals kA and kB into two signals. Then, the in-phase hybrid circuit 7 outputs an output wave kX obtained by combining the constant-amplitude waves kA/2 and kB/2 with each other to an output terminal 73 and outputs an output wave Y to an output terminal 74 so that the output waves RX and Y are in phase with each other. The output wave kX is supplied to an external circuit via an output terminal 85. The output wave Y obtained at the output terminal 74 is terminated via a resistor 21. The input wave X and the wave Y are orthogonal to each other.

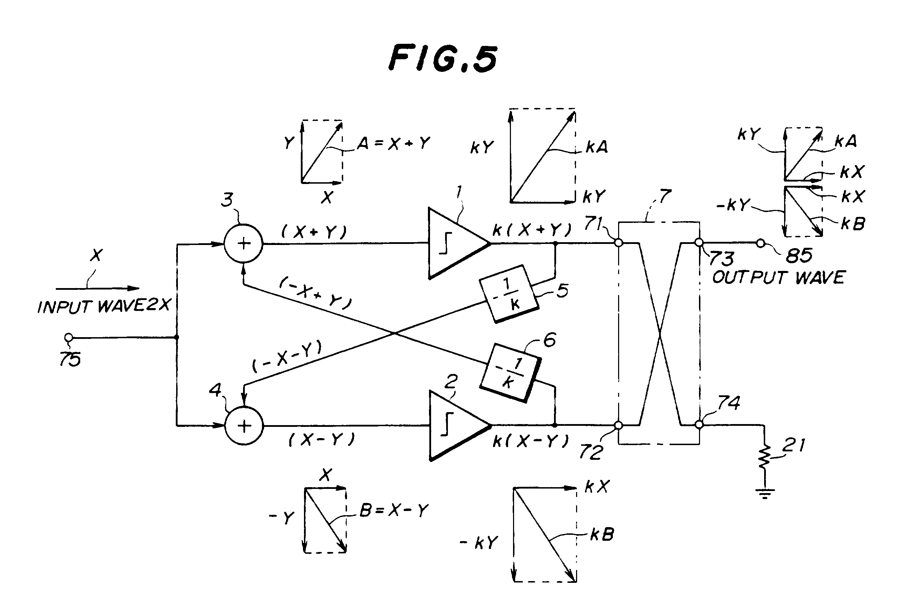

A description will now be given of the operation of the amplifier shown in FIG.3 with reference to FIGS.4 and 5. The orthogonal wave Y is assumed so that a combined vector wave obtained by combining the input wave X and the orthogonal wave Y has a constant amplitude. As shown in FIG.4, when the combined vector wave (now labeled G) obtained by combining the waves X and Y has a constant amplitude, the vector locus of the combined vector wave G moves on a part of a circle illustrated by the solid line indicated by I.

As has been described previously, the amplified signals kA and kB are fed back to the amplifiers 2 and 1 via the attenuators 5 and 6, respectively. Thus, the circuit shown in FIG.3 starts to oscillate and become stable in an oscillation state.

FIG.5 shows the amplitudes of signals which are obtained at nodes of the circuit shown in FIG.3 in a case where the input waveform has an amplitude 2X and which are represented by the assumed orthogonal wave Y. As shown in FIG.5, the output of the adder 3 is (X + Y), the output of the amplifier 1 is k(X + Y), the output of the adder 4 is (X - Y), the output of the attenuator 5 is (-X - Y), the output of the attenuator 6 is (-X + Y), and the output of the in-phase hybrid circuit 7 at its output terminal 73 is 2kX. In the above states, the circuit shown in FIG.3 stably oscillates. FIG.5 also illustrates the phase relationships between the signals at the nodes of the amplifier.

In the stable oscillation state, the output of the adder 3 is the combined vector wave obtained by combining the input wave X and the orthogonal wave Y orthogonal to the input wave X, and the combined vector wave is the constant-amplitude wave A (- X + Y) having the constant amplitude, as has been described with reference to FIG.4. Similarly, the output of the adder 4 is the combined vector wave obtained by combining the input wave X and the orthogonal wave -Y, and the combined vector wave is the constant-amplitude wave B (= X - Y) having the constant amplitude. Thus, the signals input to the amplifiers 1 and 2 have the respective constant-amplitude waves A and B in which the envelopes thereof have the constant amplitudes. As a result, it is not necessary to form the amplifiers 1 and 2 of the linear amplifiers. In other words, the amplifiers 1 and 2 can be formed of high-efficient non-linear analog amplifiers, such as C-class amplifiers.

The amplified outputs kA and kB respectively generated by the amplifiers 1 and 2 are combined by the in-phase hybrid circuit 7. In this case, the components of the orthogonal wave Y are mutually canceled at the output terminal 73, so that the output wave 2kX which are the signal components of the input wave are obtained at the output terminal 73.

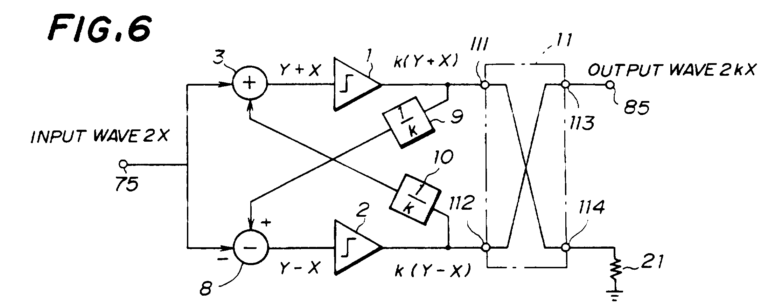

FIG.6 illustrates a variation of the amplifier shown in FIG.3. In FIG.6, those parts which are the same as those shown in the previous figures are given the same reference numerals. The variation shown in FIG.6 is different from the amplifier shown in FIG.3 in that the amplified output from the amplifier 1 is fed back to the input of the amplifier 2 via an attenuator 9 having an attenuation level 1/k and a subtracter 8, and the amplified output from the amplifier 2 is fed back to the input of the amplifier 1 via an attenuator 10 having an attenuation level 1/k and the adder 3. Further, the amplified outputs from the amplifiers 1 and 2 are input to input terminals 111 and 112, respectively, of a 180° out-of-phase hybrid circuit 11.

In the stable oscillation state, the output of the adder 3 is (Y + X), the output of the adder 8 is (Y - X) (that is, -B), the output of the amplifier 1 is k(Y + X), the output of the amplifier 2 is k(Y - X), and an output obtained at an output terminal 113 of the 180°. out-of-phase hybrid circuit 11 is 2kX. Thus, the output signals from the adder 3 and the subtracter 4 have constant envelopes having equal amplitudes, so that the amplifiers 1 and 2 can be formed of non-linear analog amplifiers.

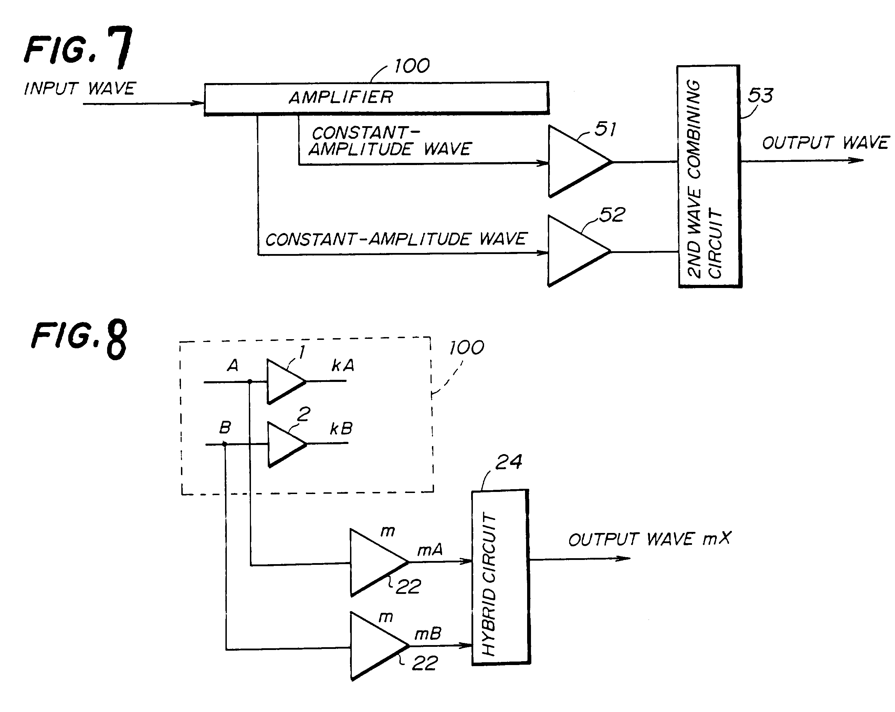

A description will now be given of a constant-amplitude wave combination type amplifier according to a second preferred embodiment of the present invention with reference to FIG.7. The amplifier shown in FIG.7 is made up of a constant-amplitude wave combination type amplifier 100, two amplifiers 51 and 52, and a second wave combining circuit 53. The constant-amplitude combination type amplifier 100 is formed of any one of the aforementioned first preferred embodiment of the present invention.

FIG.8 illustrates the configuration shown in FIG.7 in more detail. Amplifiers 22 and 23 correspond to the amplifiers 51 and 52 shown in FIG.7, respectively, and have equal amplification gains m. The amplifiers 22 and 23 receive the constant-amplitude waves A and 5, and output amplified outputs mA and mB, respectively. Alternatively, the amplifiers 22 and 23 receive the constant-amplitude waves kA and kB. A hybrid circuit 24 corresponds to the second wave combining circuit 53, and outputs an output wave mX which is an amplified version of the input wave X. Since the configuration shown in FIG.8 has the amplifiers 22 and 23 separately from the amplification circuits having the feedback loop. With this arrangement, it is possible to efficiently amplify the input wave X.

## Claims

1. A constant-amplitude wave combination type amplifier comprising:
- a first amplifier (1, 41) outputting a first amplified output wave (kA);
- a second amplifier (2, 42) outputting a second amplified output wave (kB);
- first wave combining means (45), coupled to said first and second amplifiers, for combining said first and second amplified output waves and for generating an output wave (kX),
**characterized by**
- first constant-amplitude wave generating means (43), coupled to said first and second amplifiers, for combining an input wave (X) and said second amplified output from said second amplifier and for generating a first constant-amplitude wave (A) which is input to said first amplifier;
- second constant-amplitude wave generating means (44), coupled to said first and second amplifiers, for combining said input wave and said first amplified output from said first amplifier and for generating a second constant-amplitude wave (B).

2. A constant-amplitude wave combination type amplifier as claimed in claim is characterized in that:
said first constant-amplitude wave generating means (43) comprises a first attenuator (6) which attenuates said second amplified output by a predetermined attenuation level (-1/k), and a first adder (3) having a first input terminal receiving said input wave, a second input terminal receiving said second amplified output which has passed through said first attenuator, and an output terminal which outputs said first constant-amplitude wave by adding said input wave and said second amplified output which has passed through said first attenuator;
said second constant-amplitude wave generating means (44) comprises a second attenuator (5) which attenuates said first amplified output by a predetermined attenuation level (-1/K), and a second adder (4) having a first input terminal receiving said input wave, a second input terminal receiving said first amplified output which has passed through said second attenuator, and an output terminal which outputs said second constant-amplitude wave obtained by adding said input wave and said first amplified output which has passed through said second attenuator; and
said first wave combining means (45) comprises an in-phase hybrid circuit (7) having a first input terminal receiving said first amplified output, a second input terminal receiving said second amplified output, and an output terminal which outputs said output wave.

3. A constant-amplitude wave combination type amplifier as claimed in claim 1 characterized in that:
said first constant-amplitude generating means (43) comprises a first attenuator (10) which attenuates said second amplified output by a predetermined attenuation level (-1/K), and an adder (3) having a first input terminal receiving said input wave, a second input terminal receiving said second amplified output which passes through said first attenuator, and an output terminal which outputs said first constant-amplitude wave obtained by adding said input wave and said second amplified output which has passed through said first attenuator;
said second constant-amplitude generating means (44) comprises a second attenuator (9) which attenuates said first amplified output by a predetermined attenuation level (-1/k), and a subtracter (8) having a first input terminal receiving said input wave, a second input terminal receiving said first amplified output which has passed through said second attenuator, and an output terminal which outputs said second constant-amplitude wave obtained by subtracting said input wave from said first amplified output which has passed through said second attenuator; and
said first wave combining means (45) comprises a 180°-out-of-phase hybrid circuit (11) having a first input terminal receiving said first amplified output, a second input terminal receiving said second amplified output, and an output terminal which outputs an output wave (kX).

4. A constant-amplitude wave combination type amplifier as claimed in claim 1, characterized by further comprising;
a third amplifier (22, 51) amplifying one of said first constant-amplitude wave and said first amplified output and generating a third amplified output (mA);
a fourth amplifier (23, 52) amplifying one of said second constant-amplitude wave and said second amplified output and generating a fourth amplified output (mB); and
second wave combining means (24, 53), coupled to said third and forth amplifiers, for combining said third and fourth amplified outputs and for generating an output wave (mX) which is different from said output wave (KX) generated by said first wave combining means.

## Patentansprüche

1. Verstärker des Typs, welcher Wellen konstanter Amplitude kombiniert, mit:
- einem ersten Verstärker (1, 41), welcher eine erste, verstärkte Ausgangswelle (kA) ausgibt;
- einem zweiten Verstärker (2, 42), welcher eine zweite verstärkte Ausgangswelle (kB) ausgibt;
- ersten Wellenkombinationseinrichtungen (45), die mit den ersten und zweiten Verstärkern gekoppelt sind, um die ersten und zweiten verstärkten Ausgangswellen zu kombinieren, und zum Erzeugen einer Ausgangswelle (KX),
**gekennzeichnet**, durch
- erste Konstantamplitudenwellen-Erzeugungseinrichtungen (43), die mit den ersten und zweiten Verstärkern gekoppelt sind, um eine Eingangswelle (X) und die zweite verstärkte Ausgabe von dem zweiten Verstärker zu kombinieren, und zum Erzeugen einer ersten Welle (A) konstanter Amplitude, welche in den ersten Verstärker eingegeben wird;
- zweite Konstantamplitudenwellen-Erzeugungseinrichtungen (44), die mit den ersten und zweiten Verstärkern gekoppelt sind, um die Eingangswelle und die erste, verstärkte Ausgabe von dem ersten Verstärker zu kombinieren, und zum Erzeugen einer zweiten Welle (B) konstanter Amplitude.

2. Verstärker des Typs, welcher Wellen konstanter Amplitude kombiniert, nach Anspruch 1, dadurch gekennzeichnet, daß
die erste Konstantamplitudenwellen-Erzeugungseinrichtung (43) einen ersten Abschwächer (6) umfaßt, welcher die zweite verstärkte Ausgabe um ein vorbestimmtes Abschwächungsniveau (-1/k) abschwächt, sowie einen ersten Addierer (3) mit einem ersten Eingangsanschluß, welcher die Eingangswelle empfängt, einem zweiten Eingangsanschluß, welcher die zweite verstärkte Ausgabe empfängt, die durch den ersten Abschwächer gelaufen ist, und einem Ausgangsanschluß, welcher die erste Welle konstanter Amplitude durch Addieren der Eingangswelle und der zweiten verstärkten Ausgabe ausgibt, die durch den ersten Abschwächer gelaufen ist;
die zweite Konstantamplitudenwellen-Erzeugungseinrichtung (44) einen zweiten Abschwächer (5) umfaßt, welcher die erste verstärkte Ausgabe um ein vorbestimmtes Abschwächungsniveau (-1/k) abschwächt, sowie einen zweiten Addierer (4) mit einem ersten Eingangsanschluß, welcher die Eingangswelle empfängt, einem zweiten Eingangsanschluß, welcher die erste verstärkte Ausgabe empfängt, die durch den zweiten Abschwächer gelaufen ist, und einem Ausgangsanschluß, welcher die zweite Welle konstanter Amplitude ausgibt, die durch Addieren der Eingangswelle und der ersten verstärkten Ausgabe erhalten wird, die durch den zweiten Abschwächer gelaufen ist; und
die erste Wellenkombinationseinrichtung (45) einen Inphasen-Hybridschaltkreis (7) mit einem ersten Eingangsanschluß umfaßt, welcher die erste verstärkte Ausgabe empfängt, einem zweiten Eingangsanschluß, welche die zweite verstärkte Ausgabe empfängt, und einem Ausgangsanschluß, welcher die Ausgangswelle ausgibt.

3. Verstärker des Typs, welcher Wellen konstanter Amplitude kopmbiniert, nach Anspruch 1, dadurch gekennzeichnet, daß
die erste Konstantamplituden-Erzeugungseinrichtung (43) einen ersten Abschwächer (10) umfaßt, welcher die zweite verstärkte Ausgabe um ein vorbestimmtes Abschwächungsniveau (-1/k) abschwächt, sowie einen Addierer (3) mit einem ersten Eingangsanschluß, welcher die Eingangswelle empfängt, einem zweiten Eingangsanschluß, welcher die zweite verstärkte Ausgabe empfängt, die durch den ersten Abschwächer läuft, und einem Ausgangsanschluß, welcher die erste Welle konstanter Amplitude ausgibt, die erhalten wird durch Addieren der Eingangswelle und der zweiten verstärkten Ausgabe, die durch den ersten Abschwächer gelaufen ist;
die zweite Konstantamplituden-Erzeugungseinrichtung (44) einen zweiten Abschwächer (9) umfaßt, der die erste verstärkte Ausgabe um ein vorbestimmtes Abschwächungsniveau (-1/k) abschwächt, sowie einen Subtrahierer (8) mit einem ersten Eingangsanschluß, welcher die Eingangswelle empfängt, einem zweiten Eingangsanschluß, welcher die erste verstärkte Ausgabe empfängt, die durch den zweiten Abschwächer gelaufen ist, und einem Ausgangsanschluß, welcher die zweite Welle konstanter Amplitude ausgibt, die erhalten wird durch Subtrahieren der Eingangswelle von der ersten verstärkten Ausgabe, die durch den zweiten Abschwächer gelaufen ist; und
die erste Wellenkombinationseinrichtung (45) einen 180°- Außerphase-Hybridschaltkreis (11) mit einem ersten Eingangsanschluß umfaßt, der die erste verstärkte Ausgabe empfängt, einem zweiten Eingangsanschluß, der die zweite verstärkte Ausgabe empfängt, und einem Ausgangsanschluß, welcher eine Ausgangswelle (kX) ausgibt.

4. Verstärker des Typs, welcher Wellen konstanter Amplitude kombiniert, nach Anspruch 1, gekennzeichnet durch
einen dritten Verstärker (22, 51), welcher die erste Welle konstanter Amplitude oder die erste verstärkte Ausgabe verstärkt und eine dritte verstärkte Ausgabe (mA) erzeugt;
einen vierten Verstärker (23, 52), welcher die zweite Welle konstanter Amplitude oder die zweite verstärkte Ausgabe verstärkt und eine vierte verstärkte Ausgabe (mB) erzeugt; und
zweite Wellenkombinationseinrichtungen (24, 53), die mit den dritten und vierten Verstärkern gekoppelt sind, um die dritten und vierten, verstärkten Ausgaben zu kombinieren, und zum Erzeugen einer Ausgangswelle (mX), welche von der durch die erste Wellenkombinationseinrichtung erzeugte Ausgangswelle (kX) verschieden ist.

## Revendications

1. Amplificateur du type à combinaison d'ondes d'amplitude constante, comprenant:
- un premier amplificateur (1, 41) délivrant une première onde amplifiée de sortie (kA);
- un second amplificateur (2, 42) délivrant une seconde onde amplifiée de sortie (kB);
- un premier moyen (45) de combinaison d'ondes, couplé audit premier et audit second amplificateur, pour combiner ladite première et ladite seconde onde amplifiées de sortie et pour créer une onde de sortie (kX),
caractérisé par
- un premier moyen (43) de création d'une onde d'amplitude constante, couplé audit premier et audit second amplificateur, pour combiner une onde d'entrée (X) et ladite seconde sortie amplifiée provenant dudit second amplificateur, et pour créer une première onde (A) d'amplitude constante qui constitue l'entrée dudit premier amplificateur;
- un second moyen (44) de création d'une onde d'amplitude constante, couplé audit premier et audit second amplificateur, pour combiner ladite onde d'entrée et ladite première sortie amplifiée provenant dudit premier amplificateur, et pour créer une seconde onde (B) d'amplitude constante.

2. Amplificateur du type à combinaison d'ondes d'amplitude constante selon la revendication 1, caractérisé en ce que:
ledit premier moyen (43) de création d'une onde d'amplitude constante comprend un premier atténuateur (6) qui atténue ladite second sortie amplifiée d'un niveau d'atténuation (-1/k) prédéterminé, et un premier additionneur (3) présentant une première borne d'entrée recevant ladite onde d'entrée, une seconde borne d'entrée recevant ladite seconde sortie amplifiée qui a traversé ledit premier atténuateur, et une borne de sortie qui délivre ladite première onde d'amplitude constante par addition de ladite onde d'entrée et de ladite seconde sortie amplifiée qui a traversé ledit premier atténuateur;
ledit second moyen (44) de création d'une onde d'amplitude constante comprend un second atténuateur (5) qui atténue ladite première sortie amplifiée d'un niveau d'atténuation (-1/k) prédéterminé, et un second additionneur (4) présentant une première borne d'entrée recevant ladite onde d'entrée, une seconde borne d'entrée recevant ladite première sortie amplifiée qui a traversé ledit second atténuateur, et une borne de sortie qui délivre ladite seconde onde d'amplitude constante obtenue par addition de ladite onde d'entrée et de ladite première sortie amplifiée qui a traversé ledit second atténuateur; et
ledit second moyen (45) de combinaison d'ondes comprend un circuit hybride en phase (7) dont une première borne d'entrée reçoit ladite première sortie amplifiée, une seconde borne d'entrée reçoit ladite seconde sortie amplifiée et une borne de sortie délivre ladite onde de sortie.

3. Amplificateur du type à combinaison d'ondes d'amplitude constante selon la revendication 1, caractérisé en ce que:
ledit premier moyen (43) de création d'une onde d'amplitude constante comprend un premier atténuateur (10) qui atténue ladite seconde sortie amplifiée d'un niveau d'atténuation (-1/k) prédéterminé, et un additionneur (3) dont une première borne d'entrée reçoit ladite onde d'entrée, une seconde borne d'entrée reçoit ladite seconde sortie amplifiée qui a traversé ledit premier atténuateur, et une borne de sortie qui délivre ladite première onde d'amplitude constante obtenue par addition de ladite onde d'entrée et de ladite seconde sortie amplifiée qui a traversé ledit premier atténuateur;
ledit second moyen (44) de création d'une onde d'amplitude constante comprend un second atténuateur (9) qui atténue ladite première sortie amplifiée d'un niveau d'atténuation (-1/k) prédéterminé, et un soustracteur (8) dont une première borne d'entrée reçoit ladite onde d'entrée, une seconde borne d'entrée reçoit ladite première sortie amplifiée qui a traversé ledit second atténuateur, et une borne de sortie qui délivre ladite seconde onde d'amplitude constante obtenue par soustraction de ladite onde d'entrée de ladite première sortie amplifiée qui a traversé ledit second atténuateur; et
ledit premier moyen (45) de combinaison d'ondes comprend un circuit hybride (11) déphasé de 180°, dont une première borne d'entrée reçoit ladite première sortie amplifiée, une seconde borne d'entrée reçoit ladite seconde sortie amplifiée et une borne de sortie délivre une onde de sortie (kX).

4. Amplificateur du type à combinaison d'ondes d'amplitude constante selon la revendication 1, caractérisé en ce qu'il comprend en outre:
un troisième amplificateur (22, 51) amplifiant l'une parmi ladite première onde d'amplitude constante et ladite première sortie amplifiée, et créant une troisième sortie amplifiée (mA);
un quatrième amplificateur (23, 52) amplifiant l'une parmi ladite seconde onde d'amplitude constante et ladite seconde sortie amplifiée, et créant une quatrième sortie amplifiée (mB); et
un second moyen (24, 53) de combinaison d'ondes, couplé audit troisième et audit quatrième amplificateur, pour combiner ladite troisième et ladite quatrième sortie amplifiée, en vue de créer une onde de sortie (mX) qui est différente de ladite onde de sortie (kX) créée par ledit premier moyen de combinaison d'ondes.
